# EUROPÄISCHE PATENTSCHRIFT

(11) **EP 3 049 763 B1**
(45) Veröffentlichungstag und Bekanntmachung des Hinweises auf die Patenterteilung: **06.05.2020**
(21) Anmeldenummer: 14777294.1
(22) Anmeldetag: 25.09.2014
(51) Int. Cl.: G01D 5/20, G01D 18/00, G01R 31/02, G01R 31/06

(54) **VERFAHREN ZUM TESTEN EINES TRANSFORMATORS**
METHOD FOR TESTING A TRANSFORMER
PROCÉDÉ POUR TESTER UN TRANSFORMATEUR

(30) Priorität: 27.09.2013 DE 102013219657
(43) Veröffentlichungstag der Anmeldung: 03.08.2016
(73) Patentinhaber: Continental Teves AG & Co. OHG, 60488 Frankfurt am Main (DE)
(72) Erfinder: LEHMANN, Sören, 65934 Frankfurt (DE)
(86) Internationale Anmeldenummer: PCT/EP2014/070563
(87) Internationale Veröffentlichungsnummer: WO 2015/044307

(56) Entgegenhaltungen:
- EP-A1- 0 238 922
- DE-A1- 4 425 903
- FR-A1- 2 848 300
- US-A1- 2007 146 942
- YU-A- 17 702

## Beschreibung

Die Erfindung betrifft ein Verfahren zum Testen eines Transformators, eine Steuervorrichtung zur Durchführung des Verfahrens und den Transformator.

Aus der DE 44 259 03 C3 und der EP 238 922 B1 sind Transformatoren bekannt, die als Positionssensoren nach dem Prinzip der linearen Wegmessung basierend auf einer permanentmagnetischen linearen kontaktlosen Verschiebung, PLCD genannt, arbeiten. Derartige Positionssensoren sind auch als lineare induktive Positionssensor, LIPS genannt, bekannt.

Das Dokument US2007/0146942 A1 offenbart ein Verfahren gemäß dem Stand der Technik.

Es ist Aufgabe der Erfindung, allgemein Transformatoren zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Verfahren zum Testen eines Transformators mit einer ersten Induktivität und einer von der ersten Induktivität galvanisch getrennten zweiten Induktivität, die entsprechend in einem ersten Schaltkreis und in einem zweiten Schaltkreis verschaltet sind, die Schritte Anlegen einer Gleichspannung zwischen einem ersten Schalkreispunkt und einem zweiten Schaltkreispunkt in dem ersten Schaltkreis, Abgreifen einer Testspannung zwischen zwei Schaltkreispunkten im ersten oder zweiten Schaltkreis, wobei einer der beiden Schaltkreispunkte vom ersten Schalkreispunkt und zweiten Schaltkreispunkt verschieden ist und Testen des Transformators basierend auf einer Gegenüberstellung der Gleichspannung und der Testspannung.

Dem angegebenen Verfahren liegt die Überlegung zugrunde, dass ein Transformator mit zwei galvanisch getrennten Induktivitäten physikalisch bedingt nur mit einer Wechselspannung betrieben werden kann, da Gleichspannungen durch die galvanische Trennung nicht zwischen den Induktivitäten übertragen werden können. Hier setzt das angegebene Verfahren mit der Erkenntnis an, dass eine an die beiden Induktivitäten angelegte Gleichspannung auf die Funktion des Transformators, eine Wechselspannung zwischen den beiden Induktivitäten zu übertragen, keine Auswirkungen haben darf. Auf der anderen Seite führt eine an eine der beiden Induktivitäten angelegte Gleichspannung in dem entsprechenden Schaltkreis dieser Induktivität an bestimmten Schaltungspunkten zu erwartbaren Gleichspannungspotentialen. Daher können diese Schaltungspunkte auf die erwartbaren Gleichspannungspotentiale hin überwacht werden. Werden beispielsweise die beiden Induktivitäten aufgrund eines Kurzschlusses galvanisch miteinander verbunden, würde das Gleichspannungspannungspotential an dem überwachten Schaltungspunkt vom erwartbaren Gleichspannungspotential abweichen, so dass der Fehler eindeutig erkannt werden kann.

In diesem Zusammenhang sollen unter Schaltungspunkten nachstehen Punkt in der ersten oder zweiten Schaltung verstanden werden, die sich bei einer angelegten elektrischen Spannung an diese Schaltungen in ihrem elektrischen Potential unterscheiden.

In einer Weiterbildung des angegebenen Verfahrens wird beim Testen des Transformators ein Fehler erkannt, wenn ein erfasstes Übertragungsverhalten zwischen der Testspannung und der Gleichspannung von einem vorbestimmten Übertragungsverhalten zwischen der Testspannung und der Gleichspannung in einem fehlerfreien Betrieb des Transformators abweicht. Durch die Überwachung des Übertragungsverhaltens ist das oben genannte erwartbare Gleichspannungspotential nicht auf einen bestimmten Wert fixiert und kann daher auch dann verifiziert werden, wenn sich die Gleichspannung temperatur- oder altersbedingt verändert.

Prinzipiell kann das Verfahren hinsichtlich des Anlegens der Gleichspannung und des Abgriffs der Testspannung beliebig ausgeführt werden, wobei die Gleichspannung beispielsweise an die erste Induktivitäten des Transformators angelegt und die Testspannung an der zweiten Induktivität des Transformators abgegriffen wird. Insbesondere in dem Fall, dass das angegebene Verfahren in einem als Positionssensor verwendeten Transformator angewendet wird, ist das Anlegen der Gleichspannung und das Abgreifen der Testspannung auf der Seite der ersten Spule besonders günstig, wenn die erste Spule als Sekundärspule verwendet wird. Auf diese Weise können nicht nur Kurschlüsse zur Primärspule sondern auch zu weiteren Sekundärspulen ermittelt werden, die in linearen Positionssensoren notwendig sind, um von der zu ermittelnden Position lineare Ausgangssignale mit Wechselspannungen zu erzeugen.

In einer besonderen Weiterbildung des angegebenen Verfahrens ist die erste Induktivität im ersten Schaltkreis zusätzlich Teil eines das Übertragungsverhalten vorgebenden Testschaltkreises mit wenigstens einem, die erste Induktivität mittels der Gleichspannung auf ein festes Potential legenden Widerstandes, wobei die Gleichspannung und die Testspannung entsprechend an den Testschaltkreis angelegt und in dem Testschaltkreis abgegriffen werden. Dieser Weiterbildung liegt die Überlegung zugrunde, dass Induktivitäten aus Gleichspannungssicht Kurzschlüsse darstellen und bei fehlenden weiteren Widerständen zu sehr hohen Gleichströmen führen, wenn die Gleichspannung angelegt ist. Daher wird im Rahmen der besonderen Weiterbildung vorgeschlagen, die erste Induktivität über einen Widerstand, wie beispielsweise einen Teilungswiderstand basierend auf der Gleichspannung auf ein vorbestimmtes Potential zu legen und die Gleichströme durch die erste Induktivität so klein wie möglich zu halten.

Gemäß der Erfindung ist eine Ausführungsvorrichtung eingerichtet, eines der angegebenen Verfahren durchzuführen.

In einer Weiterbildung der angegebenen Ausführungsvorrichtung weist die angegebene Ausführungsvorrichtung einen Speicher und einen Prozessor auf. Dabei ist eines der angegebenen Verfahren in Form eines Computerprogramms in dem Speicher hinterlegt und der Prozessor zur Ausführung des Verfahrens vorgesehen, wenn das Computerprogramm aus dem Speicher in den Prozessor geladen ist. Gemäß einem weiteren Aspekt der Erfindung umfasst ein Computerprogramm Programmcodemittel, um alle Schritte eines der angegebenen Verfahren durchzuführen, wenn das Computerprogramm auf einem Computer oder einer der angegebenen Vorrichtungen ausgeführt wird.

Gemäß einem weiteren Aspekt der Erfindung enthält ein Computerprogrammprodukt einen Programmcode, der auf einem computerlesbaren Datenträger gespeichert ist und der, wenn er auf einer Datenverarbeitungseinrichtung ausgeführt wird, eines der angegebenen Verfahren durchführt.

Gemäß der Erfindung umfasst ein Transformator einen ersten Schaltkreis mit einer ersten Induktivität, einen zweiten Schaltkreis mit einer von der ersten Induktivität galvanisch getrennten und mit der ersten Induktivität gekoppelten zweiten Induktivität und eine der angegebenen Ausführungsvorrichtung.

Gemäß der Erfindung, umfasst der angegebene Transformator einen die erste Induktivität enthaltenden Testschaltkreis mit wenigstens zwei Widerständen zum Anlegen der Gleichspannung und Abgreifen der Testspannung, wobei der Testschaltkreis eine galvanische Abkopplung von einer Erdung, insbesondere über einen Kondensator aufweist. Der zweite Widerstand ist neben dem oben genannten ersten Widerstand optional und kann zur Ausführung der vorliegenden Weiterbildung auch weggelassen werden. Durch die galvanische Trennung von der Erdung wird der Testschaltkreis aus Sicht der Wechselspannung geerdet, so dass aus Sicht der Wechselspannung nur der erste Schaltkreis, nicht jedoch der Testschaltkreis vorhanden ist.

Ist die galvanische Trennung ein Kondensator, so sollte das eingangs genannte Verfahren in der Ausführungsvorrichtung dann durchgeführt werden, wenn mit dem Transformator Wechselspannungen mit hohen Frequenzen, beispielsweise im oder oberhalb des kHz-Bereichs übertragen werden. Auf diese Weise kann für den Kondensator eine kleine Kapazität gewählt werden, so dass der Blindwiderstand des Kondensators vernachlässigt werden kann. In einer zusätzlichen Weiterbildung des angegebenen Transformators bilden die Widerstände einen Spannungsteiler aus wobei die erste Induktivität in Reihe zwischen den beiden Widerständen verschaltet ist. Auf diese Weise kann das weiter oben erwähnte Übertragungsverhalten durch eine geeignete Dimensionierung der beiden Widerstände bestimmt werden und es ist unter der oben genannten Bedingung, dass die Testspannung wenigstens an einem Schaltungspunkt abgegriffen werden soll, an dem nicht die Gleichspannung angelegt ist, ein sich deutlich von den anderen Schaltungspunkten unterscheidender dritter Schaltungspunkt vorhanden, an dem die Testspannung abgegriffen werden kann. In einer besonderen Weiterbildung des angegebenen Transformators ist ein erster der beiden Widerstände von der ersten Induktivität aus gesehen der Erdung gegenüberliegend und zwischen dem ersten Widerstand und der ersten Induktivität ein Transformatorabgriff angeordnet. Auf diese Weise kann mit dem ersten Widerstand gleichzeitig der Eingangs- oder Ausgangswiderstand des Transformators beeinflusst werden, um ein am Transformator anliegendes Signal (das dem Transformator zugeführt oder abgeführt wird) optimal mit einer an den Transformator angeschlossenen Schaltung auszutauschen.

Dazu ist der erste Widerstand bevorzugt hochohmig. Der Ausdruck Hochohmigkeit bezieht sich auf den zuvor genannten Eingangs- oder Ausgangswiderstand von elektronischen Komponenten, Schaltungen oder Messgeräten, also in diesem Fall des Transformators. Es sagt aus, dass der von einer an den Transformator angeschlossenen Schaltung gesehene Widerstand des Transformators einen bestimmten Widerstandswert überschreitet. In der Regel spricht man von hochohmig, wenn der Widerstand einen zweistelligen Kilo-Ohm-Wert überschreitet, also über 10 Kilo-Ohm liegt. Die Hochohmigkeit ist nach oben hin unbegrenzt.

In einer besonders bevorzugten Weiterbildung des angegebenen Verfahrens ist ein zweiter der beiden Widerstände in Reihe mit einer Spannungsquelle zur Abgabe der Gleichspannung parallel zum Kondensator geschaltet. Mit diesem zweiten Widerstand kann damit das oben genannte feste Potential an die erste Induktivität des Transformators angelegt werden, um den Transformator in besonders günstiger Weise erfindungsgemäß mit der Gleichspannung auf Kurschlüsse und Unterbrechungen zu überwachen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 in einer perspektivischen Ansicht einen Tandemhauptzylinder mit einem Wegsensor zeigen,
Fig. 2 in einer seitlichen Schnittansicht den Wegsensor aus Fig. 1,
Fig. 3 in einer perspektivischen Ansicht einen Teil des Wegsensors aus Fig. 2,
Fig. 4 eine perspektivische Ansicht des Wegsensors der Fig. 3,
Fig. 5 eine Gleichspannungsersatzschaltung der Schaltung aus Fig. 4,
Fig. 6 eine Gleichspannungsersatzschaltung der Schaltung aus Fig. 4 in einem ersten Fehlerfall,
Fig. 7 eine Gleichspannungsersatzschaltung der Schaltung aus Fig. 4 in einem zweiten Fehlerfall, und
Fig. 8 eine Gleichspannungsersatzschaltung der Schaltung aus Fig. 4 in einem dritten Fehlerfall zeigen.

In den Figuren werden gleiche technische Elemente mit gleichen Bezugszeichen versehen und nur einmal beschrieben.

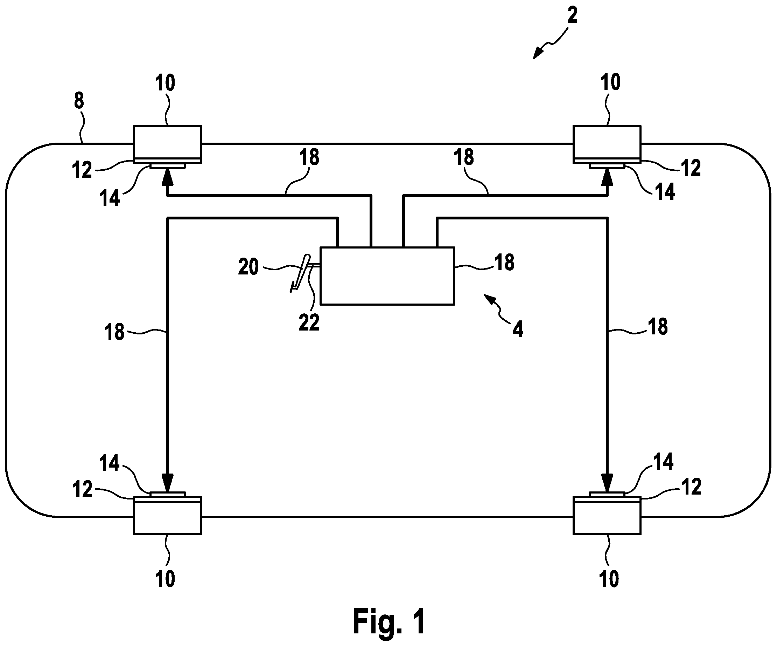

Es wird auf Fig. 1 Bezug genommen, die eine Prinzipdarstellung eines Fahrzeuges 2 mit einer Betriebsbremse 4 und einer Feststellbremse 6 zeigt.

Das Fahrzeug 2 weist ein Chassis 8 auf, das auf einer nicht weiter dargestellten Straße auf vier Rädern 10 über einen nicht weiter dargestellten Motor angetrieben rollen kann. An den einzelnen Rädern 10 sind in der vorliegenden Ausführung Bremsscheiben 12 drehfest befestigt, an denen noch zu beschreibende drehfest zum Chassis 8 befestigte Bremseffektoren angreifen können, um die Räder 10 in einer an sich bekannten Weise zu blockieren und das Fahrzeug 2 aus der Fahrt heraus abzubremsen oder im Stillstand festzuhalten.

In der vorliegenden Ausführung weist die Betriebsbremse 4 je einen Betriebsbremseffektor 14, wie beispielsweise eine Bremsbacke, an jedem Rad 10 auf. Diese Betriebsbremseffektoren 14 werden von einem Tandemhauptzylinder 16 über hydraulische Leitungen 18 basierend auf einer mit einem Bremspedal 20 vorgebbaren Betriebsbremsanforderung 22 in einer an sich bekannten Weise angesteuert.

Die Erfindung wird nachstehend anhand eines in dem Tandemhauptzylinder 16 verwendeten Wegsensors 24 mit einem Transformator näher erläutert. Es sei an dieser Stelle darauf hingewiesen, dass die nachstehende Erläuterung rein exemplarisch ist, und dass sich die Erfindung auf beliebige Transformatoren anwenden lässt.

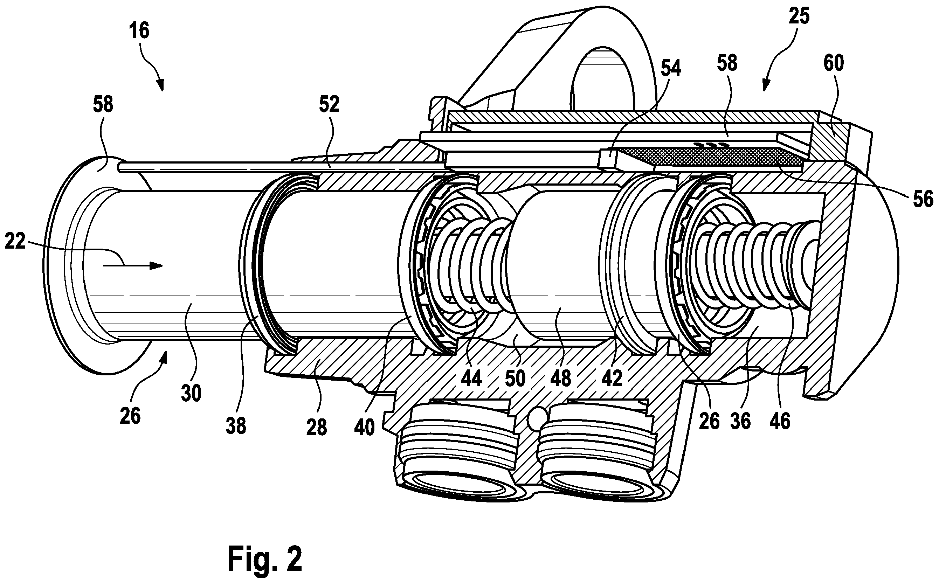

Es wird auf Fig. 2 Bezug genommen, die den Tandemhauptzylinder 16 mit einem Wegsensor 25 zeigt.

Der Tandemhauptzylinder 16 weist ferner einen Druckkolben 26 auf, der Betriebsbremsanforderung 22 in einem Gehäuse 28 beweglich angeordnet ist, wobei der Druckkolben 26 mit dem Bremspedal 20 aus Fig. 1 in nicht weiter dargestellter Weise verbunden ist. Der Druckkolben 26 selbst ist in einen Primärkolben 30 und einen Sekundärkolben 32 unterteilt, wobei der Primärkolben 30 einen Eingang des Gehäuses 28 verschließt und der Sekundärkolben 32 den Innenraum des Gehäuses 28 in eine Primärkammer 34 und eine Sekundärkammer 36 unterteilt. Im Bereich des Eingangs des Gehäuses 28 ist am Primärkolben 30 eine Sekundärmanschette 38 angeordnet, die den Innenraum des Gehäuses 28 von der Umgebungsluft isoliert. In den Innenraum des Gehäuses 28 hinein gesehen folgt nach der Sekundärmanschette 38 eine Primärmanschette 40, die einen Spalt zwischen dem Primärkolben 30 und einer Wand des Gehäuses 28 abdichtet. Eine Druckmanschette 42 am Sekundärkolben 32 isoliert den Druck der Primärkammer 34 vom Druck der Sekundärkammer 36. Ferner dichtet eine weitere Primärmanschette 40 am Sekundärkolben 32 einen Spalt zwischen dem Sekundärkolben 32 und der Wand des Gehäuses 28 ab. Der Primärkolben 30 ist gegen den Sekundärkolben 32 über eine erste Feder 44 abgestützt, während der Sekundärkolben 32 gegen einen Gehäuseboden über eine zweite Feder 46 abgestützt ist. Über einen ersten und zweiten Anschluss 48, 50 können entsprechend die Primärkammer 34 und die Sekundärkammer 36 mit nicht gezeigter Hydraulikflüssigkeit versorgt werden.

Da dem Fachmann die Funktionsweise eines Tandemhauptzylinders bekannt ist, soll auf eine detaillierte Darstellung dieser verzichtet werden.

Der Wegsensor 24 weist einen Probekörper in Form eines Schiebers 52 mit einem Gebermagneten 54 an seinem Kopfende auf, der in die Bildebene hinein betrachtet unter einen noch zu beschreibenden Sensorschaltkreis 56 geschoben werden kann. Zum Schieben des Schiebers 52 weist der Primärkolben 30 einen Flansch 58 auf, an dem der Schieber 52 gegengelagert ist. Der Flansch 58 und der Primärkolben 30 bilden damit gemeinsam ein Messobjekt, dessen Position durch die noch zu beschreibenden Sensorschaltkreis 56 des Wegsensors 25 ermittelt wird. Der Sensorschaltkreis 56 ist aus mehreren Leiterbahnen auf einem Verdrahtungsträger 58, wie einem Leadframe, einer Leiterplatte oder einem anderen Substrat gebildet. Auf die Leiterplatte 58 mit dem Sensorschaltkreis 38 kann zum Schutz beispielsweise vor Schmutz ein Deckel 60 aufgelegt sein.

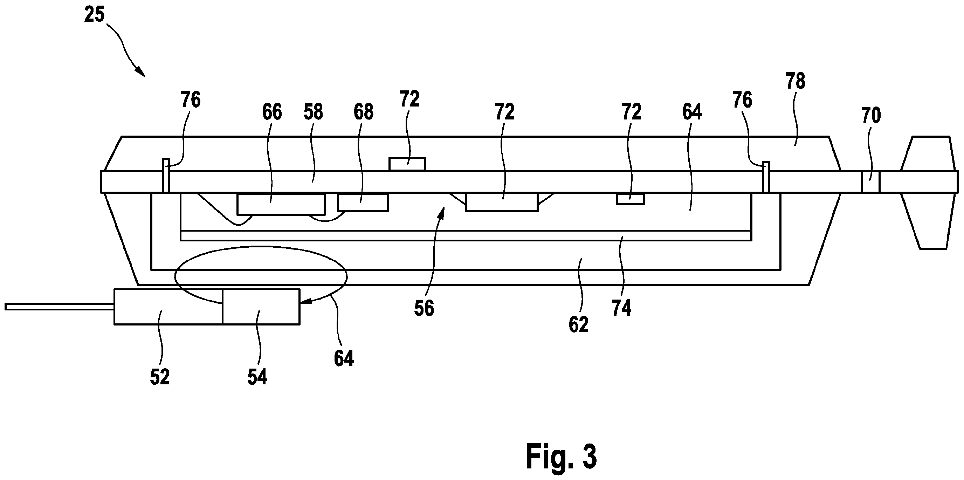

Es wird auf Fig. 3 Bezug genommen, die den Wegsensor 25 aus Fig. 2.

Der Sensorschaltkreis 56 des Wegsensors umfasst einen Transformator 62. Der Transformator 62 erfasst ein magnetisches Feld 64 des Gebermagneten 37 und gibt darauf basierend ein nicht näher referenziertes elektrisches Gebersignal an den Sensorschaltkreis 56 aus. Dieses Gebersignal wird von einem ersten Signalverarbeitungschip 66 und einem zweiten Signalverarbeitungschip 68 in ein nicht näher referenziertes Messsignal umgewandelt, aus dem die Lage des Schiebers 52 und damit die Lage des Flansches 58 und des Primärkolbens 30 hervorgeht. Das so erzeugte Messsignal kann abschließend an einer Sendeschnittstelle 70 des Wegsensors 25 über ein nicht weiter dargestelltes Kabel abgegriffen und zu einer nicht weiter dargestellten höheren Signalverarbeitungseinheit wie beispielsweise einer Motorsteuerung in einem nicht weiter dargestellten Fahrzeug weitergeleitet werden.

Der Sensorschaltkreis 56 kann Schutzelemente 72 zum Schutz der beiden Signalverarbeitungschips 66, 68 beispielsweise vor einer Überspannung umfassen. Ferner kann zwischen dem Sensorschaltkreis 56 und dem Transformator 62 eine Abschirmplatte 74 angeordnet sein, die elektromagnetische Felder zwischen dem Sensorschaltkreis 56 und dem Transformator 62 abschirmt und so einen Einfluss des Schaltkreises 56 auf den Transformator 62 vermeidet.

In der vorliegenden Ausführung ist der Transformator 62 über einen Formschluss 76 in einer definierten Lage auf dem Verdrahtungsträger 58 angeordnet. Dabei umgibt den Verdrahtungsträger 58 und den Transformator 62 eine Schutzmasse 78.

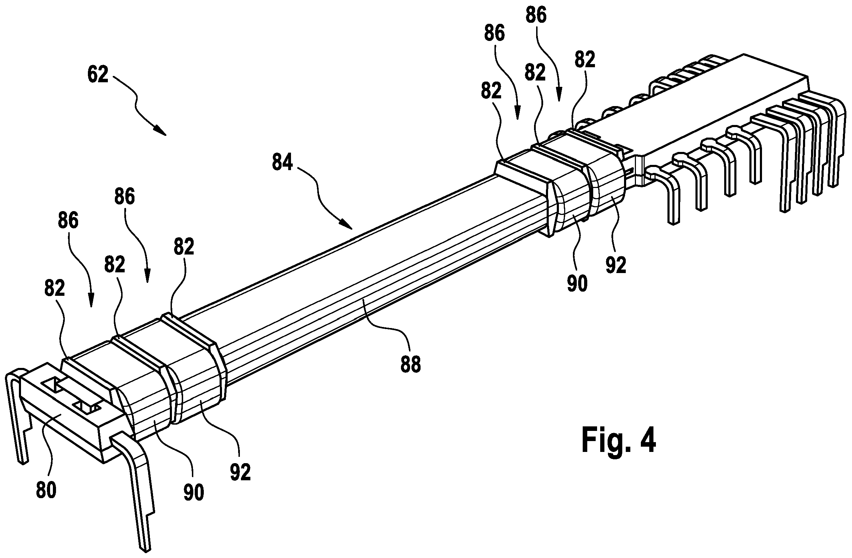

In Fig. 4 ist eine perspektivische Ansicht des Transformators 62 dargestellt. Der Transformator 62 umfasst einen Spulenträger 80 mit einem Wicklungsraum, der über sechs Stege 82 in einen Mittelabschnitt 84 und vier Seitenabschnitte 86 gegliedert ist. Der Spulenträger 80 trägt eine sich entlang eines in Fig. 4 nicht weiter sichtbare Kerns erstreckende Primärspule 88, welche im vorliegenden Fall als einlagig angenommen werden soll. An den beiden gegenüberliegenden Randzonen der Primärspule 88 trägt der Spulenträger 80 dicht gewickelte erste Sekundärspulen 90 und zweite Sekundärspulen 92 zur Messung einer Induktionsspannung, wobei an den beiden Enden der Primärspule 88 paarweise je eine erste Sekundärspule 90 und eine zweite Sekundärspule 92 angeordnet ist.

Die Spulen 88, 90, 92 sind über Anschlusspins 94 mit dem Sensorschaltkreis 56 auf dem Verdrahtungsträger 58 elektrisch kontaktierbar.

Der Wegsensor 25 mit einem Transformator, wie der Transformator 62 wird normalerweise als Differenztrafowegsensor bezeichnet. Alternativ kann der Wegsensor 25 aber auch nur mit je einer Sekundärspule an den Enden der Primärspule aufgebaut werden, wozu beispielsweise auf die Druckschriften DE 44 259 03 C3 und der EP 238 922 B1 verwiesen wird.

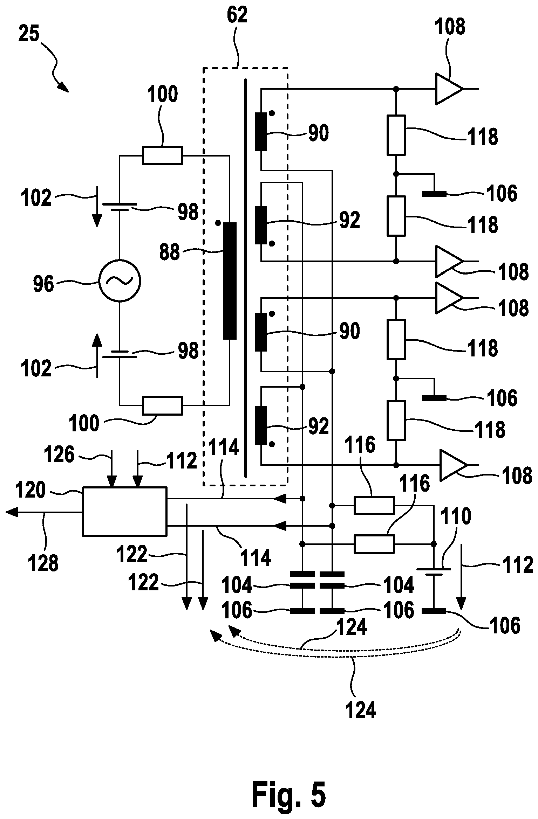

Anhand des in Fig. 5 dargestellten Schaltbildes soll zunächst die Funktion des Wegsensors 25 erläutert werden.

Zum Betrieb des Wegsensors 25 an die Primärspule des Transformators 62 eine Reihenschaltung aus einer elektrischen Eingangswechselspannungsquelle 96 und zwei antipodal zueinander geschalteten Eingangsgleichspannungsquellen 98 angeschlossen. Die Eingangsgleichspannungsquellen 98 legen an die Wicklungsenden der Primärspule 88 über Eingangswiderstände 100 ein gleiches Potential 102 an und sorgen dafür, dass durch die Primärspule 88 kein Gleichstrom fließen kann, aber die Primärspule 88 dennoch auf einem definierten, festen und niederimpedanten Gleichpotenzial liegt.

Dabei wird eine nicht weiter referenzierte Wechselspannung der Eingangswechselspannungsquelle 96 in dem Transformator 62 des Wegsensors 25 von der Primärspule 88 auf die Sekundärspulen 90, 92 übertragen.

In dem Transformator 62 des Wegsensors 25 ist die Primärspule 88 mit den ersten Sekundärspulen 90 gleichgekoppelt, was heißt, dass die Wicklungen der Primärspule 88 und der ersten Sekundärspulen 90 gleichsinnig gewickelt sind. Demgegenüber ist die Primärspule 88 mit den zweiten Sekundärspulen 92 gegengekoppelt, was heißt, dass die Wicklungen der Primärspule 88 und der zweiten Sekundärspulen 92 gegensinnig gewickelt sind.

Die ersten Sekundärspulen 90 sind auf der einen Seite über einen ersten Erdungskondensator 104 mit einer Erdung 106, das heißt einem fest definierten Potential verbunden während die zweiten Sekundärspulen über einen zweiten Erdungskondensator 104 ebenfalls mit der Erdung 106 verbunden sind. Auf der anderen Seite sind die ersten und zweiten Sekundärspulen 90, 92 mit Verstärkern 108 verbunden, an deren nicht weiter referenzierten Ausgängen eine übertragene Wechselspannung gegenüber der Erdung 106 abgegriffen werden kann, die die in die Primärspule 88 eingespeiste und an die Sekundärspulen 90, 92 übertragene Wechselspannung darstellt.

Im Betrieb des Wegesensors 62 wird der in Fig. 2 und 3 gezeigte Gebermagnet 54 durch den Schieber 58 entlang der Spulen 88, 90, 92 bewegt, wodurch sich in an sich bekannter Weise ein Kopplungsfaktor zwischen den Spulen 88, 90, 92 verändert. Bei einer vorbestimmten, aus der Eingangswechselspannungsquelle 96 abgegebenen Wechselspannung verändert sich auf diese Weise die übertragene Wechselspannung an den Ausgängen der Verstärker, so dass basierend auf der Veränderung der übertragenen Wechselspannung eine Positionsänderung des Gebermagneten 54 und damit des Schiebers 58 erfasst werden kann. Einzelheiten zur Funktionsweise von linearen Positionssensoren können beispielsweise den oben genannten Druckschriften entnommen werden.

Voraussetzung hierzu ist jedoch, dass der Transformator frei von galvanischen Verbindungen zwischen der Primärspule 88, den ersten Sekundärspulen 90 und den zweiten Sekundärspulen 92 ist. Auch sollten im Schaltbild der Fig. 5 vor allem sekundärseitig am Transformator 62 keine Unterbrechungen vorhanden sein. Dies soll im Rahmen der vorliegenden Ausführung mit einer sekundärseitig an den Transformator 62 angeschlossenen Referenzgleichspannungsquelle 110 überwacht werden, die eine Referenzgleichspannung 112 ausgibt. Jede der Sekundärspulen 90, 92 ist in der vorliegenden Ausführung an einen Mittelabgriff 114 eines Spannungsteilers zwischen einem ersten Spannungsteilerwiderstand 116 und einem zweiten Spannungsteilerwiderstand 118 angeschlossen, wobei sich die ersten Sekundärspulen 90 und die zweiten Sekundärspulen 92 je einen ersten Spannungsteilerwiderstand 116 teilen. Die Referenzgleichspannungsquelle 110 ist dabei parallel an die Spannungsteiler 116, 118 angeschlossen.

An die Mittelabgriffe 114 ist in der vorliegenden Ausführung eine Überwachungs- oder Testvorrichtung 120 angeschlossen, die ein Test- oder Überwachungsverfahren ausführt, um die in Fig. 5 dargestellte Schaltung auf galvanische Unterbrechungen oder nicht beabsichtige Verbindungen hin zu überwachen.

Dazu greift die Testvorrichtung 120 an den Mittelabgriffen 114 je eine Testgleichspannung 122 ab, die das elektrische Gleichspannungspotential an den Mittelabgriffen 114 beispielsweise gegenüber der Erdung 106 darstellt. Jede Testgleichspannung 122 ist mit einem in Fig. 5 angedeuteten Übertragungsverhältnis 124 von der Referenzgleichspannung 112 abhängig. Diese Abhängigkeit ist dabei für den Fall, dass die in Fig. 5 gezeigte Schaltung keine Fehler in Form von galvanischen Unterbrechungen und unbeabsichtigten galvanischen Verbindungen aufweist, durch die jeweiligen Spannungsteiler und dabei insbesondere durch die einzelnen Spannungsteilerwiderstände 116, 118 bestimmt.

Zur Überwachung der in Fig. 5 dargestellten Schaltung kann die Testvorrichtung 120 daher neben den Testgleichspannungen 124 auch die Referenzgleichspannung 112 und ein vorbestimmtes Übertragungsverhältnis 126 empfangen. Basierend auf dem vorbestimmten Übertragungsverhältnis 126 und der Referenzgleichspannung 112 kann die Testvorrichtung 120 eine in Fig. 5 nicht weiter dargestellte Testgleichspannung für den fehlerfreien Fall bestimmen und verifizieren, ob die gemessenen Testgleichspannungen 122 mit dieser Testgleichspannung für den fehlerfreien Fall übereinstimmt. Im Fehlerfall, wenn also eine gemessene Testgleichspannung 122 von der Testgleichspannung für den fehlerfreien Fall abweicht, kann die Testvorrichtung 120 ein Fehlersignal 128 ausgeben, mit dem beispielsweise in dem Fahrzeug 2 ein Warnhinweis ausgegeben werden kann.

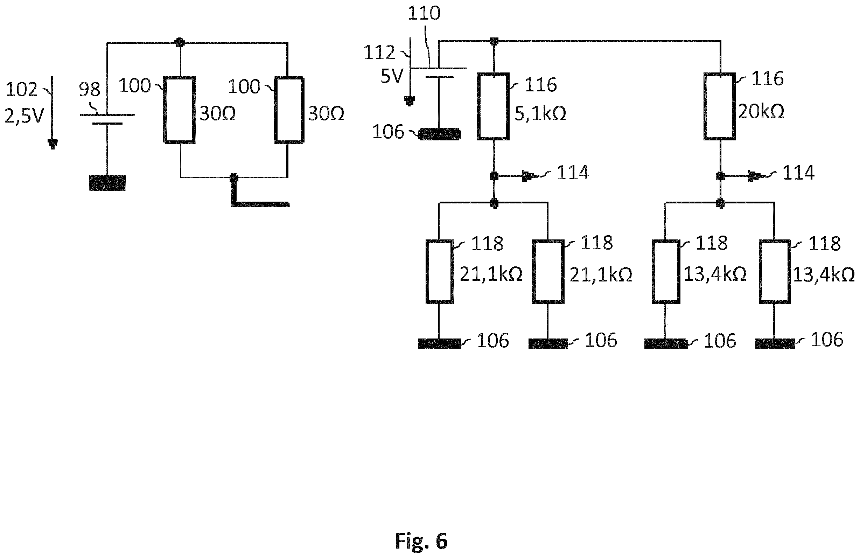

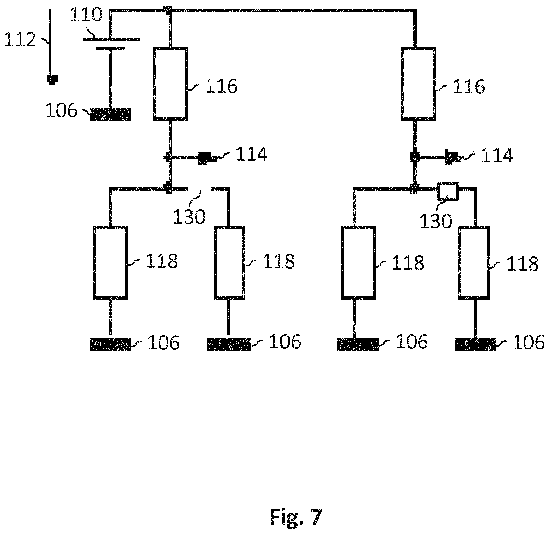

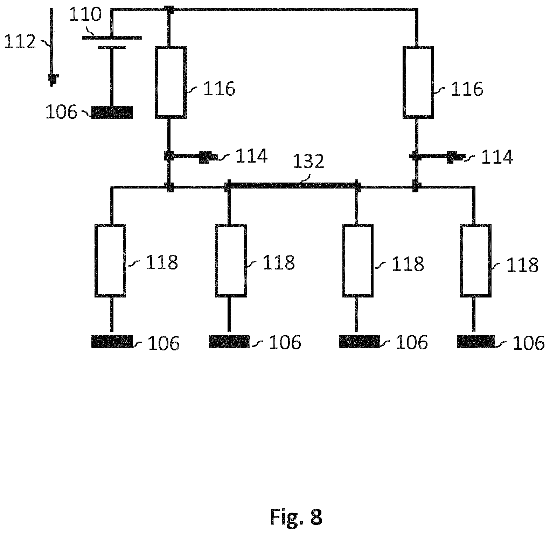

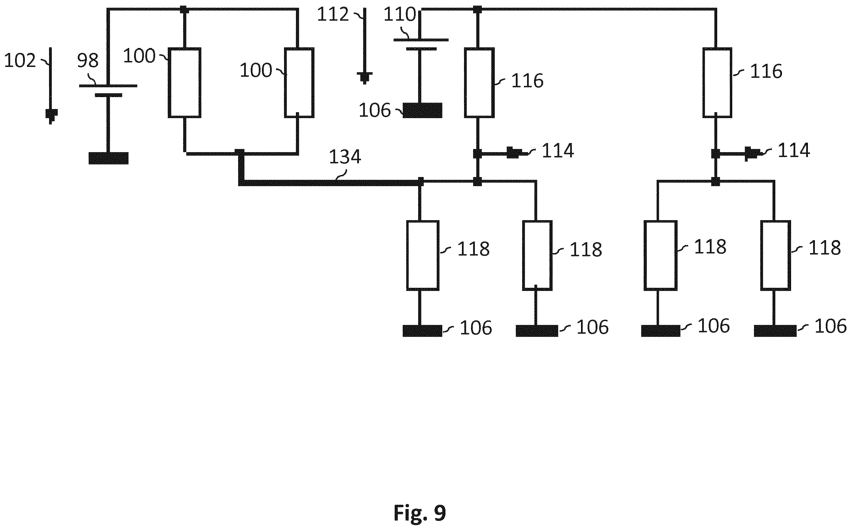

In Fig. 6 ist die Schaltung aus Fig. 5 als Gleichstromersatzschaltbild in einem fehlerfreien Zustand mit dimensionierten Werten für die Gleichstromkomponenten der Schaltung dargestellt. Demgegenüber sind in den Fig. 7 bis 9 verschiedene Fehlszenarien für die Schaltung aus Fig. 5 dargestellt. Dabei soll in Fig. 7 eine galvanische Unterbrechung 130 in einer der Sekundärspulen 90, 92, in Fig. 8 eine galvanische Verbindung 132 zwischen den ersten und zweiten Sekundärspulen 90, 92, nachstehend Sekundärseitenkurzschluss 132 genannt, und in Fig. 9 eine galvanische Verbindung 134 zwischen der Primärspule 88 und einer der Sekundärspulen 90, 92, nachstehend Transformatorkurzschluss 134 genannt, als Fehlerszenario angenommen werden. In Fig. 10 ist ferner ein dimensioniertes Beispiel für das Gleichstromersatzschaltbild der Schaltung aus Fig. 5 gezeigt.

Mit den in Fig. 6 gezeigten Werten für das Gleichstromersatzschaltbild der Schaltung aus Fig. 5 ergeben sich für die Testgleichspannung 122 am Mittelabgriff 114 für die in den Fig. 6 bis 9 gezeigten Szenarien Werte gemäß der folgenden Tabelle:

| Szenario | erste Testspannung 122 | zweite Testspannung 122 |
|---|---|---|
| Fig. 6 | 3,37V | 1, 26V |
| Fig. 7 | 4,03V | 2,00V |
| Fig. 8 | 2,51V | 2,51V |
| Fig. 9 | 2,50V | 2,50V |

Wie aus der Tabelle zu sehen ist, verändern sich die Testspannungen 122 gegenüber dem Normalfall aus Fig. 6. Vielmehr könnte gegebenenfalls sogar der Fehler qualifiziert und angegeben werden, um beispielsweise die betroffene Spule des Transformators 62 zu bestimmen und gegebenenfalls auszutauschen.

Wie sich insbesondere aus einem Vergleich der Testspannungen 122 in den Fig. 8 und 9 zeigt, sollten die Widerstände so eng wie möglich toleriert sein, um eine zuverlässige Auswertung zu gewährleisten, weil die Testspannungen 122 für die verschiedenen Fehlerfälle sehr nahe aneinander liegen können.

## Patentansprüche

1. Transformator (62), umfassend:
- einen ersten Schaltkreis mit einer ersten Induktivität (90, 92),
- einen zweiten Schaltkreis mit einer von der ersten Induktivität (90, 92) galvanisch getrennten und mit der ersten Induktivität (90, 92) gekoppelten zweiten Induktivität (88), die entsprechend in einem ersten Schaltkreis und in einem zweiten Schaltkreis verschaltet sind, und
- eine Vorrichtung (120) zur Durchführung eines Verfahrens zum Testen des Transformators (62) mit den Verfahrensschritten:
- Anlegen einer Gleichspannung (112) zwischen einem ersten Schalkreispunkt und einem zweiten Schaltkreispunkt (106) in dem ersten Schaltkreis;
- Abgreifen einer Testspannung (122) zwischen zwei Schaltkreispunkten (114, 106) im ersten oder zweiten Schaltkreis, wobei einer der beiden Schaltkreispunkte (114) vom ersten Schalkreispunkt und zweiten Schaltkreispunkt (106) verschieden ist; und
- Testen des Transformators (62) basierend auf einer Gegenüberstellung der Gleichspannung (112) und der Testspannung (122),
**dadurch gekennzeichnet , dass** der Transformator einen die erste Induktivität (90, 92) enthaltenden Testschaltkreis mit wenigstens zwei Widerständen (116, 118) zum Anlegen der Gleichspannung (112) und Abgreifen der Testspannung (122) umfasst, wobei der Testschaltkreis eine galvanische Abkopplung (104) von einer Erdung (106), insbesondere einen Kondensator (104) aufweist.

2. Transformator (62) nach Anspruch 1, wobei die Vorrichtung (120) zur Durchführung eines Verfahrens zum Testen des Transformators (62) geeignet ist, bei dem beim Testen des Transformators (122) ein Fehler (130, 132, 134) erkannt wird, wenn ein erfasstes Übertragungsverhalten (124) zwischen der Testspannung (122) und der Gleichspannung (112) von einem vorbestimmten Übertragungsverhalten (126) zwischen der Testspannung (122) und der Gleichspannung (112) in einem fehlerfreien Betrieb des Transformators (62) abweicht.

3. Transformator (62) nach Anspruch 2, wobei die Vorrichtung (120) zur Durchführung eines Verfahrens zum Testen des Transformators (62) geeignet ist, bei dem die erste Induktivität (90, 92) im ersten Schaltkreis zusätzlich Teil eines das Übertragungsverhalten (124) vorgebenden Testschaltkreises mit wenigstens einem, die erste Induktivität mittels der Gleichspannung (122) auf ein festes Potential (114) legenden Widerstandes (116) ist, und wobei die Gleichspannung (112) und die Testspannung (112) entsprechend an den Testschaltkreis angelegt und in dem Testschaltkreis abgegriffen werden.

4. Transformator (62) nach einem der vorhergehenden Ansprüche, wobei die Widerstände (116, 118) einen Spannungsteiler ausbilden und die erste Induktivität (90, 92) in Reihe zwischen den beiden Widerständen (116, 118) verschaltet ist.

5. Transformator (62) nach Anspruch 4, wobei ein erster der beiden Widerstände (118) von der ersten Induktivität (90, 92) aus gesehen der Erdung (106) gegenüberliegend und zwischen dem ersten Widerstand (118) und der ersten Induktivität (90, 92) ein Transformatorabgriff (108) angeordnet ist.

6. Transformator (62) nach Anspruch 5, wobei der erste Widerstand (118) hochohmig ist.

7. Transformator (62) nach Anspruch 5 oder 6, wobei ein zweiter der beiden Widerstände (116) in Reihe mit einer Spannungsquelle (110) zur Abgabe der Gleichspannung (112) parallel zum Kondensator (104) geschaltet ist.

## Claims

1. Transformer (62), comprising:
- a first circuit containing a first inductor (90, 92),
- a second circuit containing a second inductor (88) that is galvanically isolated from the first inductor (90, 92) and coupled to the first inductor (90, 92), these being accordingly connected in a first circuit and in a second circuit, and
- a device (120) for performing a method for testing the transformer (62), having the method steps of:
- applying a DC voltage (112) between a first circuit point and a second circuit point (106) in the first circuit;
- tapping off a test voltage (122) between two circuit points (114, 106) in the first or second circuit, wherein one of the two circuit points (114) is different from the first circuit point and second circuit point (106); and
- testing the transformer (62) based on a comparison of the DC voltage (112) and the test voltage (122),
**characterized in that** the transformer comprises a test circuit, containing the first inductor (90, 92), containing at least two resistors (116, 118) for applying the DC voltage (112) and tapping off the test voltage (122), wherein the test circuit has galvanic decoupling (104) from ground (106), in particular a capacitor (104).

2. Transformer (62) according to Claim 1, wherein the device (120) is suitable for performing a method for testing the transformer (62), in which, when testing the transformer (122), a fault (130, 132, 134) is detected when a recorded transformation ratio (124) between the test voltage (122) and the DC voltage (112) deviates from a predetermined transformation ratio (126) between the test voltage (122) and the DC voltage (112) in fault-free operation of the transformer (62).

3. Transformer (62) according to Claim 2, wherein the device (120) is suitable for performing a method for testing the transformer (62), in which the first inductor (90, 92) in the first circuit is additionally part of a test circuit, which predefines the transformation ratio (124), containing at least one resistor (116) that sets the first inductor to a fixed potential (114) by way of the DC voltage (122), and wherein the DC voltage (112) and the test voltage (112) are accordingly applied to the test circuit and tapped off in the test circuit.

4. Transformer (62) according to one of the preceding claims, wherein the resistors (116, 118) form a voltage divider and the first inductor (90, 92) is connected in series between the two resistors (116, 118).

5. Transformer (62) according to Claim 4, wherein a first of the two resistors (118), as seen from the first inductor (90, 92), is arranged opposite the ground (106), and a transformer tap (108) is arranged between the first resistor (118) and the first inductor (90, 92).

6. Transformer (62) according to Claim 5, wherein the first resistor (118) has a high resistance.

7. Transformer (62) according to Claim 5 or 6, wherein a second of the two resistors (116) is connected in series with a voltage source (110) in order to output the DC voltage (112) in parallel with the capacitor (104).

## Revendications

1. Transformateur (62), comportant :
- un premier circuit commuté comprenant une première inductance (90, 92),
- un deuxième circuit commuté comprenant une deuxième inductance (88) isolée galvaniquement de la première inductance (90, 92) et couplée avec la première inductance (90, 92), lesquelles sont connectées en conséquence dans un premier circuit commuté et dans un deuxième circuit commuté,
- un dispositif (120) destiné à mettre en œuvre un procédé pour tester le transformateur (62) comprenant les étapes suivantes :
- application d'une tension continue (112) entre un premier point de circuit commuté et un deuxième point de circuit commuté (106) dans le premier circuit commuté ;
- prélèvement d'une tension de test (122) entre deux points de circuit commuté (114, 106) dans le premier ou le deuxième circuit commuté, l'un des deux points de circuit commuté (114) étant différent du premier point de circuit commuté et du deuxième point de circuit commuté (106) ;
- test du transformateur (62) en se basant sur la comparaison de la tension continue (112) et de la tension de test (122),
**caractérisé en ce que** le transformateur comporte un circuit commuté de test contenant la première inductance (90, 92), avec au moins deux résistances (116, 118) destinées à l'application de la tension continue (112) et au prélèvement de la tension de test (122), le circuit commuté de test possédant un découplage galvanique (104) d'une mise à la terre (106), notamment un condensateur (104) .

2. Transformateur (62) selon la revendication 1, le dispositif (120) étant adapté pour mettre en œuvre un procédé pour tester le transformateur (62), lors duquel un défaut (130, 132, 134) est reconnu lors du test du transformateur (122) lorsqu'un comportement de transfert détecté (124) entre la tension continue (112) et la tension de test (122) diffère d'un comportement de transfert prédéterminé (126) entre la tension continue (112) et la tension de test (122) dans un fonctionnement sans défaut du transformateur (62).

3. Transformateur (62) selon la revendication 2, le dispositif (120) étant adapté pour mettre en œuvre un procédé pour tester le transformateur (62), lors duquel la première inductance (90, 92) dans le premier circuit commuté fait en plus partie d'un circuit commuté partiel supplémentaire qui prédéfinit le comportement de transfert (124), lequel comprend une résistance (116) qui met la première inductance à un potentiel fixe (114) au moyen de la tension continue (122), et la tension continue (112) et la tension de test (112) étant appliquées en conséquence au circuit commuté de test et prélevées dans le circuit commuté de test.

4. Transformateur (62) selon l'une des revendications précédentes, les résistances (116, 118) formant un diviseur de tension et la première inductance (90, 92) étant connectée en série entre les deux résistances (116, 118) .

5. Transformateur (62) selon la revendication 4, une première des deux résistances (118), vue depuis la première inductance (90, 92), étant disposée à l'opposé de la mise à la terre (106) et une prise de transformateur (108) étant disposée entre la première résistance (118) et la première inductance (90, 92).

6. Transformateur (62) selon la revendication 5, la première résistance (118) étant de valeur élevée.

7. Transformateur (62) selon la revendication 5 ou 6, une deuxième des deux résistances (116) étant branchée en série avec une source de tension (110) destinée à délivrer la tension continue (112) et en parallèle avec le condensateur (104).
